# EUROPÄISCHE PATENTSCHRIFT

(11) **EP 0 692 721 B1**
(45) Veröffentlichungstag und Bekanntmachung des Hinweises auf die Patenterteilung: **17.05.2000**
(21) Anmeldenummer: 95109879.7
(22) Anmeldetag: 24.06.1995
(51) Int. Cl.: G01V 3/14, G01R 33/44

(54) **Kompensation von Störfeldern bei NMR-Messungen im Erdmagnetfeld**
Compensation of disturbing fields during NMR measurements in the earth's magnetic field
Compensation de champs perturbateurs pendant des mesures RMN dans le champ magnétique terrestre

(30) Priorität: 14.07.1994 DE 4424842
(43) Veröffentlichungstag der Anmeldung: 17.01.1996
(73) Patentinhaber: Bruker AG, 8117 Fällanden (CH)
(72) Erfinder: Kuster, Anton, CH-8606 Greifensee (CH); Laukien, Dirk D., Dr., Lexington, MA 02173 (US)
(74) Vertreter: KOHLER SCHMID + PARTNER

(56) Entgegenhaltungen:
- GB-A- 2 198 540
- US-A- 3 441 838
- US-A- 3 538 429
- ELEKTROTECHNISCHE ZEITSCHRIFT, ETZ-B, Bd. 17, 1965 Seiten 149-152,

## Beschreibung

Die Erfindung betrifft eine Meßeinrichtung mit mindestens einer Detektionsspule zum Detektieren magnetischer Kernresonanz (NMR) aus einem Empfindlichkeitsbereich der Detektionsspule im Erdboden, wobei durch wiederholte kohärente Anregung im Empfindlichkeitsbereich jeweils Kernspins im Erdfeld zur Präzession angeregt werden und in der Detektionsspule eine kleine NMR-Induktionsspannung erzeugen, welche einem ersten Verstärker zugeführt wird, wobei mindestens eine Kompensationsspule zur zusätzlichen Kompensation räumlich inhomogener Störfelder vorgesehen ist, deren Induktionssignal einem zweiten Verstärker mit einstellbarem Verstärkungsfaktor zugeführt wird.

Eine Meßeinrichtung mit diesen Merkmalen ist in der US-A-3,019,383 beschrieben.

Wie US-A-3 441 838 zeigt ein Magnetometer, also ein Gerät zur Messung von Erdmagnetfeldern, wobei die NMR-Frequenz einer fest vorgegebenen Flüssigkeitsprobe mittels eines Spinoszillators gemessen wird. Um Störeinstrahlungen zu kompensieren wird ein Doppelspulensystem für die Detektion eingesetzt. Information über NMR-aktive Substanzen im Erdboden wird damit allerdings nicht gewonnen, sondern lediglich das lokale Erdmagnetfeld vermessen.

Ein Spulensystem für NMR-Messungen zur Gewinnung von ortsaufgelöster Information aus dem Erdboden ist beispielsweise bekannt aus der DE 36 90 746 C2. Dazu wird eine Spule auf die Erdoberfläche gelegt, die ein Wechselfeld zum Anregen magnetischer Resonanz im Erdmagnetfeld erzeugt. Mit dieser Spule wird anschließend auch das Resonanzsignal aufgrund der freien Präzession von Kernspins aus dem Erdboden gemessen.

Aus der EP 0 512 345 A1 ist zudem bekannt, ortsaufgelöste NMR-Signale aus dem Erdboden zu gewinnen, wobei durch Oberflächenspulen sowohl ein magnetisches Grundfeld, magnetische Gradientenfelder und ein Hochfrequenzfeld zur Anregung der NMR-Signale erzeugt werden.

Aus der eingangs zitierten US 3,019,383 ist bekannt, Störungen, die beim Empfang eines NMR-Signals aus einer ähnlichen Anordnung wie in der DE 36 90 746 C2 auftreten, dadurch zu eliminieren, daß man nach jeder Anregung in zwei auf Magnetband gespeicherten Empfangskanälen in einem Kanal die Störungen zusammen mit dem Nutzsignal aufzeichnet, im anderen nach einer Wartezeit nur die Störungen. Dann werden beide Kanäle simultan ausgelesen und effektiv subtrahiert. Es wird zudem über sehr viele Anregungen akkumuliert und dabei extrem gestörte Signale unterdrückt.

Ursprung der NMR-Signale ist in der Regel Feuchtigkeit im Erdreich. Die Signale sind extrem klein, so daß sie bei einer Einzelanregung im Rauschen der Meßanordnung untergehen. In einer typischen Umgebung, durchaus auch außerhalb bewohnter Gebiete wird jedoch das empfangene Signal durch Störsignale dominiert, die sich zum großen Teil (aber nicht vollständig) der Netzfrequenz von 50 Hz bzw. der Eisenbahnfrequenz von 16 2/3 Hz und ihren Oberwellen zuordnen lassen. Da zwischen den NMR-Anregungen und den Störsignalen keine feste Phasenbeziehung besteht, sollten sich bei Akkumulation sehr vieler Signale die Störungen, wie auch das Rauschen nach und nach wegmitteln. Für Störungen, die sich im Rahmen der Wiederholzeit der Anregungen nicht ändern, kann man auch ein Subtraktionsverfahren wie in der o.g. US 3,019,383 vorsehen. Dabei besteht jedoch ein Dynamikproblem, da ja das größte Störsignal die maximale Verstärkung limitiert.

Allerdings hat sich überraschenderweise in Feldversuchen gezeigt, daß räumlich homogene Fernstörungen zwar den größten Anteil an den Störsignalen einnehmen, daß aber trotzdem ein beträchtlicher Anteil an inhomogenen lokalen Störungen vorhanden ist, der durchaus auch im wesentlichen im Frequenzbereich der Netz- bzw. Bahnfrequenz und ihrer Oberwellen liegt, ohne daß in unmittelbarer Nähe Erdkabel, Überlandleitungen o.ä. vorhanden wären, die dies erklären könnten. Die magnetischen Feldlinien dieser Störanteile sind über den Bereich der Meßspulenanordnung nicht parallel und äquidistant, sondern verlaufen gekrümmt und die Feldstärke variiert räumlich.

Da die NMR-Meßspulenanordnung in der Regel waagrecht auf dem Erdboden aufliegt, kann sie nur Signalanteile detektieren, deren magnetischer Feldvektor senkrecht zur Erdoberfläche gerichtet ist (z-Richtung). Die inhomogenen Störfelder wechseln jedoch von einer Detektionsteilspule zur anderen sowohl ihre Feldstärke als auch ihre Richtung, sie werden also durch eine Anordnung mit mindestens zwei, insbesondere in der gleichen Ebene ausliegenden Spulen nicht oder nur unvollständig kompensiert.

Aufgabe der Erfindung ist es demgegenüber, eine NMR-Meßeinrichtung der eingangs genannten Art zur Gewinnung von ortsaufgelöster Information aus dem Erdboden dahingehend zu verbessern, daß die auftretenden Störsignale aufgrund räumlich inhomogener Störfelder, insbesondere auch rotierender Störfelder und Störungen von mehreren unterschiedlichen Störquellen besser eliminiert werden.

Erfindungsgemäß wird diese Aufgabe dadurch gelöst, daß die Detektionsspule aus mindestens zwei gegensinnig gewickelten, elektrisch in Serie oder parallel geschalteten Teilspulen mit parallelen Spulenachsen besteht, und daß mehrere identische, an unterschiedlichen Orten angeordnete Systeme mit jeweils mindestens drei Kompensationsspulen vorgesehen sind, die so gegeneinander verkippt angeordnet sind, daß damit jedes beliebig orientierte Vektorsignal der inhomogenen Störfelder empfangen, vektoriell rekonstruiert und zur Kompensation der Störfelder von dem aus der Detektionsspule kommenden und im Verstärker hochverstärkten Signal subtrahiert wird.

Mit dieser Anordnung werden externe Fernstörungen nahezu vollständig eliminiert.

Die Windungszahlen, Form und Fläche der Teilspulen können verändert werden, solange das Gesamtinduktionssignal einer Fernstörung minimiert wird. Durch die Verdrahtung der beiden Teilspulen noch vor der ersten Vorverstärkerstufe werden Fernstörungen frühzeitig kompensiert und gar nicht erst verstärkt, was die Dynamikprobleme entscheidend reduziert. Die erste Verstärkerstufe kann mit wesentlich größerer Verstärkung arbeiten ohne in die Sättigung zu geraten.

Die Induktionssignale der Kompensationspulen zur zusätzlichen Kompensation räumlich inhomogener Störfelder werden demjenigen der Detektionsspule in individuell abgeschwächter Form zu einem Gesamtsignal überlagert. Damit kann jedes beliebig orientierte Vektorsignal vollständig empfangen und rekonstruiert werden. Durch die Verwendung von mehreren identischen Systemen mit jeweils mindestens drei Kompensationsspulen an unterschiedlichen Orten können die inhomogenen Störungen mehrerer unterschiedlicher Störquellen, insbesondere auch rotierende Störfelder besser kompensiert werden.

Besonders bevorzugt ist eine Ausführungsform, bei der die Kompensationsspulen eines jeden Systems jeweils drei gegenseitig orthogonal angeordnete Spulen sind. Die Rekonstruktion des damit empfangenen Vektorsignales ist bei dieser Ausführungsform besonders einfach.

Bei einer weiteren Ausführungsform der erfindungsgemäßen Meßeinrichtung ist vorgesehen, daß die räumliche Positionierung, die Windungszahlen, die Querschnittsflächen und die Permeabilität des Spulenmaterials der Teilspulen der Detektionsspule so ausgewählt sind, daß ein räumlich homogenes magnetisches Stör-Wechselfeld in der Detektionsspule in guter Näherung keine Induktionsspannung erzeugt, während ein im Vergleich zur Störung kleines NMR-Signal aus dem Empfindlichkeitsbereich der gesamten Detektionsspule im Erdboden nicht kompensiert wird.

Die Verbindungslinie der Mittelpunkte der Teilspulen der Detektionsspule ist vorzugsweise in Ost-West-Richtung ausgerichtet. Das erzeugte Anregungsmagnetfeld B₁ steht dann im wesentlichen senkrecht zum Erdmagnetfeld B₀, so daß mit der entsprechend ausgerichteten Detektionsspule die Anregungssignale maximal empfangen werden können.

Besonders bevorzugt ist auch eine Ausführungsform der erfindungsgemäßen Meßeinrichtung, bei der mindestens eine der Teilspulen der Detektionsspule in räumlichem Abstand von der Erdoberfläche angeordnet ist, so daß von ihr weitgehend kein NMR-Signal aus den unter ihr liegenden Bodenkonstrukturen empfangen wird. Dadurch wird sichergestellt, daß die andere Teilspule definiert und nahezu alleine das empfindliche Meßvolumen für die NMR-Signale aus den zu untersuchenden Erdbodenbereichen empfängt, während die über dem Boden angeordnete Teilspule lediglich der Kompensation von Fernstörungen dient.

Vorteilhaft ist eine Weiterentwicklung dieser Ausführungsform, bei der die von der Erdoberfläche entfernt angeordnete Teilspule im Verhältnis zu einer auf der Erdoberfläche plazierten anderen Teilspule der Detektionsspule klein ist und eine hohe Windungszahl aufweist. Damit kann die von der Erdoberfläche entfernt angeordnete Teilspule, die in der Regel auf einem Dreibein oder einem geeigneten Gerüst montiert sein wird, besonders kompakt und leicht gestaltet werden, so daß der zusätzliche mechanische Aufwand für ihre Halterung gering ist.

Vorteilhaft ist eine Ausführungsform, bei der die von der Oberfläche entfernt angeordnete Teilspule mit ihrer Spulenebene im wesentlichen parallel zur Erdoberfläche angeordnet ist. Da die auf dem Erdboden angeordnete Teilspule (oder Teilspulen) der Detektionsspule ebenfalls im wesentlichen parallel zur Erdoberfläche ausgerichtet sind, empfangen sämtliche Teilspulen der Detektionsspule im wesentlichen den gleichen Vektor einer Fernstörung.

Besonders bevorzugt ist eine Weiterbildung dieser Ausführungsform, bei der die Verbindungslinie der Mittelpunkte der von der Erdoberfläche entfernt angeordneten Teilspule und einer unterhalb von dieser auf der Erdoberfläche plazierten Teilspule im wesentlichen senkrecht zur Erdoberfläche steht. Damit wird das empfindliche Meßvolumen fast ausschließlich durch die am Boden liegende Teilspule definiert, während von der kompakten, über den Mittelpunkt der Bodenspule angeordneten oberen Teilspule lediglich die Fernfeldanteile der Störungen und nur noch ein unbedeutend geringer Anteil des Nahfeldes aufgrund der im Boden vorliegenden Strukturen empfangen wird.

Vorteilhaft ist auch eine Ausführungsform, bei der die von der Erdoberfläche entfernt angeordnete Teilspule der Detektionsspule ein Kühlsystem zur Kühlung der Spule aufweist. Dies ist insbesondere aufgrund der kompakten Ausgestaltung der oberen Teilspule problemlos realisierbar. Durch die Kühlung wird der ohmsche Widerstand und damit das elektrische Rauschen der als Fernfeldkompensationspule wirkenden oberen Teilspule wesentlich verringert.

Die im Vergleich zur Detektionsspule in der Regel sehr kleinen Kompensationsspulen müssen nicht mehr mit der Detektionsspule einfach in Serie geschaltet sein. Ihre Induktionssignale können individuell derart abgeschwächt (bzw. verstärkt) werden, daß das Gesamtsignal von Detektionsspule und Kompensationsspule(n) minimal wird. Dies kann elektronisch geschehen. Grundsätzlich ist jedoch auch eine mechanische Abstimmung denkbar, etwa durch Drehen der Kompensationsspulen, durch Verschieben oder z.B. durch Verändern des Überlapps zweier gegenläufiger Teil-Kompensationsspulen. In diesen Fällen könnte die Serienschaltung mit der Haupt-Detektionsspule erhalten bleiben, was den Vorteil hätte, daß die Kompensation nach wie vor vor der ersten Verstärkung stattfindet.

Bevorzugt ist jedoch eine Variante, bei der den Kompensationsspulen individuelle einstellbare Verstärker nachgeschaltet sind, so daß erst die verstärkten, ggf. erst die digitalisierten Meßsignale aus Detektionsspule und Kompensationsspulen überlagert werden. Die Verstärkungsfaktoren können von Hand oder automatisch so eingestellt werden, daß das Gesamtsignal minimiert wird. Dabei werden die Kompensationsspulen vorzugsweise so positioniert, daß sie das zu kompensierende Störsignal maximal empfangen, um den Rauschbeitrag des Kompensationszweigs niedrig zu halten. Die Orientierung weicht dabei wegen der oben geschilderten Drehung der Feldlinienrichtung i.a. von der z-Richtung ab. Eine mögliche Erklärung für dieses Phänomen könnte sein, daß im Erdboden über leitfähige Schichten Erdströme fließen, die durchaus weit entfernte Quellen und Senken verbinden. Diese Verbindungspfade sind nicht der direkte Weg, sondern werden durch die lokale Zusammensetzung des Erdreichs, dabei im wesentlichen vom Wassergehalt, bestimmt.

Besonders bevorzugt ist daher die oben beschriebene Kompensationsspulenanordnung aus drei im wesentlichen identischen Teilkompensationsspulen, die orthogonal aufeinander stehen und deren Beitrag zum Kompensationssignal individuell eingestellt werden kann. Damit ist es möglich, bei einmal aufgestellter Kompensationspulenanordnung die Kompensation auf rein elektronischem Weg zu optimieren und einer beliebigen Drehung der Feldlinienrichtung des Störfelds zwischen Detektionsspule und Kompensationsspule zu folgen.

Die Kompensationspulenanordnung sollte so aufgebaut sein und plaziert werden, daß kein oder nur ein vernachlässigbar kleines NMR-signal induziert wird.

Dies ist scheinbar bereits bei der Aufteilung der Detektionsspule in zwei Teilspulen ein Problem. Da jedoch ein NMR-Signal nur im Nahbereich unter der Spule angeregt wird, ist das NMR-Signal kein Fernfeld, das durch diese Anordnung kompensiert werden würde. Der Detektionsbereich einer Zweispulenanordnung beispielsweise in Form einer liegenden Acht ist anders als der einer Einzelspule, aber er ist durchaus vorhanden. In den jeweiligen Spulenflächen stehen die Feldlinien im wesentlichen senkrecht auf diesen nach oben bzw. nach unten. Unter der Spulenanordnung schließen sie sich so, daß sie in der Tiefe weitgehend waagrecht verlaufen. Die Teilspulen der Acht sollten möglichst so plaziert sein, daß die Feldlinien diejenigen des Erdmagnetfeldes unter Winkeln schneiden, die nahe an 90° sind.

Gegenstand der Erfindung ist auch ein Verfahren zum Messen magnetischer Kernresonanz im Erdboden mit Hilfe einer Meßeinrichtung der oben beschriebenen Art, das dadurch gekennzeichnet ist, daß durch wiederholte kohärente Anregung jeweils Kernspins aus dem Empfindlichkeitsbereich der Detektionsspule im natürlichen Magnetfeld der Erde zur Präzession angeregt werden und in der Detektionsspule ein kleines NMR-Induktionssignal erzeugen, und daß dem Induktionssignal in der Detektionsspule mit entgegengesetztem Vorzeichen Induktionssignale aus den Komponentenspulen zu einem Gesamtsignal überlagert werden, wobei die Gesamtsignale aller Anregungen akkumuliert werden.

Das Verfahren kann sich dadurch auszeichnen, daß die Detektionsspule aus mindestens zwei gegensinnigen Teilspulen besteht, deren Orientierungen, Windungszahlen und Querschnittsflächen so gewählt und die so zu der gesamten Detektionsspule verschaltet sind, daß ein räumlich homogenes magnetisches Störwechselfeld in dieser in guter Näherung keine Induktionsspannung erzeugt, daß aber ein im Vergleich zur Störung kleines NMR-Signal aus dem Empfindlichkeitsbereich der gesamten Detektionsspule im Erdboden nicht kompensiert wird, daß mittels eines Wechselfeldgenerators und eines Leistungsverstärkers ein Wechselstrompuls durch die Detektionsspule geschickt wird, der den Frequenzbereich der magnetischen Resonanz einer Kernspinart, vorzugsweise von Protonen, im Erdmagnetfeld enthält, daß anschließend das freie Induktionssignal der Detektionsspule verstärkt, digitalisiert und abgespeichert wird, und daß der Anregungs-, Verstärkungs-, Digitalisierungsvorgang mehrere Male wiederholt wird, wobei die digitalisierten Induktionssignale phasenrichtig akkumuliert werden.

Besonders bevorzugt ist eine Variante des erfindungsgemäßen Verfahrens, bei der die Induktionssignale aus den Kompensationsspulen so verstärkt werden, daß das Gesamtsignal von Detektionsspule und Kompensationsspulen minimiert wird. Da der ganz überwiegende Hauptanteil des mit der Detektionsspule aufgenommenen Signales seine Ursache in Störfeldern hat, während das eigentlich nützliche NMR-Signal im Rauschen "versteckt" ist, werden durch Minimierung des Gesamtsignals von Detektionsspule und Kompensationsspulen im wesentlichen nur "schädliche" Signalanteile ausgelöscht. Auch der noch verbleibende, wesentlich kleinere Signalanteil besteht zum größten Teil noch aus Rauschen, das sich aber durch sehr langes Akkumulieren wegmitteln läßt, während sich die "nützlichen" Signalanteile aufgrund von Kernspinresonanz im Erdmagnetfeld kohärent aufaddieren.

Besonders bevorzugt ist eine Variante des erfindungsgemäßen Verfahrens, bei der das gesamte Induktionssignal der Kompensationsspulen durch entsprechende Plazierung der Kompensationsspulen in der Nähe der Detektionspule maximiert wird. Dadurch kann der Ort der größten lokalen Feldstörung ermittelt und die letztere aus der Messung eliminiert werden.

Bei einer Weiterbildung dieser Verfahrensvariante wird nach Plazierung die räumliche Orientierung der Kompensationsspulen so variiert, daß das gesamte Induktionssignal aus den Kompensationsspulen maximal wird. Damit wird die stärkste lokale inhomogene Feldstörung auch vektoriell voll erfaßt.

Besonders einfach ist eine Weiterbildung dieser Verfahrensvariante, bei der vorgesehen ist, daß nach Maximierung des gesamten Induktionssignales der Kompensationsspulen lediglich eine einzige Kompensationsspule mit der gleichen Plazierung so orientiert wird, daß sie entsprechend dem mit Hilfe der Vielzahl von Kompensationsspulen aufgefundenen Störfeldvektor das maximal mögliche Störsignal an dieser Stelle aufnimmt, und daß das Signal aus der einzigen Kompensationsspule von dem Signal aus der Detektionsspule subtrahiert wird, wobei durch Variation eines Verstärkungsfaktors für das Signal aus der Kompensationsspule das zeitliche Integral über das gleichgerichtete Differenzsignal minimiert wird. Damit ist nur ein einziger Verstärker erforderlich, wodurch die Kosten für die Meßeinrichtung verringert werden. Gleichzeitig wird der Rauschanteil im gemessenen Signal kleiner, da nur noch das elektronische Rauschen von einem einzigen Verstärker dem Signal aus der Kompensationsspule überlagert ist.

Bei einer alternativen Verfahrensvariante wird das durch Plazieren der Kompensationsspule maximierte Induktionssignal vor einer Gleichrichtung von dem Signal aus der Detektionsspule subtrahiert, wobei individuelle Verstärkungsfaktoren für jede einzelne Kompensationsspule derart variiert werden, daß das zeitliche Integral über das gleichgerichtete Differenzsignal minimal wird. Eine räumliche Orientierung der einzelnen Kompensationsspulen erübrigt sich, da die Ausrichtung nach dem lokalen Feldstörungsvektor gewissermaßen elektronisch erfolgt.

Eine weitere Verfahrensvariante zeichnet sich dadurch aus, daß nach der Plazierung der Kompensationsspulen deren gesamtes Induktionssignal durch Variation von individuellen Verstärkungsfaktoren für jede einzelne Kompensationsspule maximiert wird, und daß anschließend das optimierte Signal aus den Kompensationsspulen von dem Signal aus der Detektionsspule subtrahiert wird, wobei durch Variation eines gemeinsamen Verstärkungsfaktors für das gesamte Signal aus den Kompensationsspulen das zeitliche Integral über das gleichgerichtete Differenzsignal minimiert wird. Auf diese Weise muß lediglich ein einziger Verstärkungsfaktor optimiert werden.

Da das eigentliche Meßsignal immer so klein ist, daß es im Rauschen der Einzelmessung verschwindet, können bei einer Variante Störungen weiter dadurch minimiert werden, daß die Variation des bzw. der Verstärkungsfaktoren mit Hilfe eines Fitverfahrens, insbesondere mit dem Linear-Prediction-Verfahren oder mit dem Maximum-Entropy-Verfahren erfolgt. Dadurch können auch kurzzeitige Störungen, die sich nur in der Einzelmessung signifikant bemerkbar machen, gezielt eliminiert werden.

Vorzugsweise erfolgt das Anfitten des Spektrums mit dem Linear-Prediction-Verfahren oder dem Maximum-Entropy-Verfahren in einem dazu geeigneten Rechner.

Das akkumulierte, digitalisierte zeitliche Signal aus der Detektionsspule und der oder den Kompensationsspulen kann entweder vor oder nach der Akkumulation fouriertransformiert werden, um ein Frequenzspektrum der NMR-Signale aus dem untersuchten Bereich des Erdbodens zu erhalten. Insbesondere können die fouriertransformierten Signale besonders gut zur Gewinnung eines NMR-Bildes des untersuchten Bereiches verwendet werden.

Die oben beschriebenen Varianten des erfindungsgemäßen Verfahrens können sinnvollerweise auch mit den in DE 36 90 746 C2 oder EP 0 512 345 A1 offenbarten Verfahren zur Ortsauflösung kombiniert werden.

Durch entsprechende Gewichtung der aus den Kompensationsspulen gelieferten Induktionssignale kann auch eine breitbandige Phasenkompensation bei Dreh-Störfeldern erreicht werden. Weiterhin können das "timing" und die Phasen der Anregungsimpulse so gewählt werden, daß sich über mehrere Anregungen zeitweise kohärente Störungen wegmitteln, die Signalphase aber gezielt springt und das Signal phasenrichtig akkumuliert wird. Derartige Phasendrehungen des Anregungsimpulses sind beispielsweise aus den Verfahren PAPS, CYCLOPS oder dem Verfahren der pseudostatistischen Phasenänderungen an sich bekannt. Die Phasenänderungen können anti-korreliert mit den Basisstörfrequenzen bzw. ihren Oberwellen (50 Hz, 16 2/3 Hz etc.) sein, was durch Triggerung mit der entsprechenden Frequenz erreicht wird.

Weitere Vorteile der Erfindung ergeben sich aus der Beschreibung und der Zeichnung. Ebenso können die vorstehend genannten und die noch weiter aufgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1: ein schematisches Blockschaltbild für die Verschaltung der erfindungsgemäßen Meßeinrichtung;
- Fig. 2: eine schematische räumliche Darstellung einer auf einem Ausschnitt der Erdoberfläche ausgelegten erfindungsgemäßen Detektionsspule mit den entsprechenden Magnetfeldverteilungen;
- Fig. 3: eine Ausführungsform eines orthogonalen Kompensationsspulen-Systems gemäß der Erfindung;
- Fig. 4: eine Ausführungsform der erfindungsgemäßen Detektionsspule mit einer räumlich vom Erdboden entfernten Teilspule zur Kompensation der Fernfeldstörungen; und
- Fig. 5: eine schematische Darstellung der relativen Lage von Detektions- und Kompensationsspule relativ zu einer lokalen inhomogenen Feldstörung, wobei
a) keine Kompensation bzw.
b) optimale Kompensationswirkung erzielt wird.

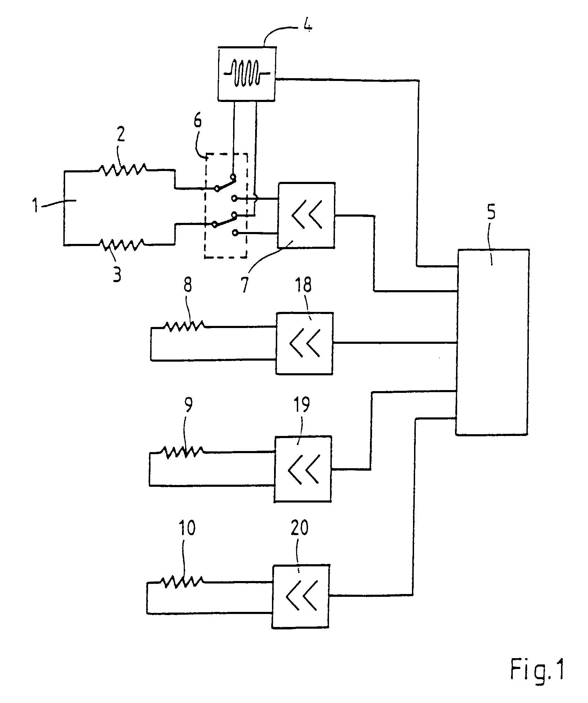

Die elektrische Verschaltung der erfindungsgemäßen Meßreinrichtung ist schematisch in Fig. 1 gezeigt. Eine Detektionsspule 1 zum Detektieren von NMR-Signalen aus dem Empfindlichkeitsbereich der Detektionsspule 1 im Erdboden besteht aus zwei elektrisch in Serie geschalteten Teilspulen 2, 3. Aus einem Niederfrequenz(NF)-Generator 4, der von einem Rechner 5 gesteuert wird, werden über einen elektronischen Schalter 6 niederfrequente Anregungsimpulse zur kohärenten Anregung magnetischer Resonanzen auf die Detektionsspule 1 geleitet. Danach wird der Schalter 6 umgeschaltet und die Detektionsspule 1 kann die angeregten NMR-Signale aus dem Erdboden empfangen, welche über einen Verstärker 7 an den Rechner 5 weitergeleitet werden.

Die beiden Teilspulen 2 und 3 sind gegensinnig zueinander gewickelt und dienen beide sowohl zur Anregung wie auch zur Aufnahme des Meßsignals. Aus diesem Grund unterstützen sich beide Teilspulen bei der Aufnahme des Meßsignals. Ein homogenes Störfeld hingegen induziert in den beiden Teilspulen 2 und 3 gegensinnige Spannungen, die sich größtenteils am Eingang des Verstärkers 7 kompensieren.

Zur zusätzlichen Kompensation räumlich inhomogener Störfelder sind vorzugsweise untereinander orthogonal angeordnete Kompensationsspulen 8, 9, 10 vorgesehen, deren Signale jeweils von einem zugeordneten Verstärker 18, 19, 20 hochverstärkt und an den Rechner 5 weitergeleitet werden. Die Verstärkungsfaktoren für die Signale aus den einzelnen Kompensationsspulen 8, 9, 10 werden im Rechner 5 individuell so gewichtet, daß mit der Kompensationsspulenanordnung, 8, 9, 10 das Vektorsignal des inhomogenen Störfeldes optimal rekonstruiert wird. Dieses wird dann von dem aus der Detektionsspule 1 kommenden und im Verstärker 7 hochverstärkten Signal subtrahiert, um auch die Störanteile räumlich inhomogener Störfelder zu kompensieren. Zusätzlich kann im Rechner 5 den aus den Verstärkern 18, 19, 20 kommenden Signalen ein Summenwert zugeordnet werden, der seinerseits mit einem Verstärkungsfaktor derart versehen wird, daß die Differenz zwischen dem Signal aus der Detektionsspule 1 und dem genannten Summensignal im zeitlichen Mittel minimiert wird.

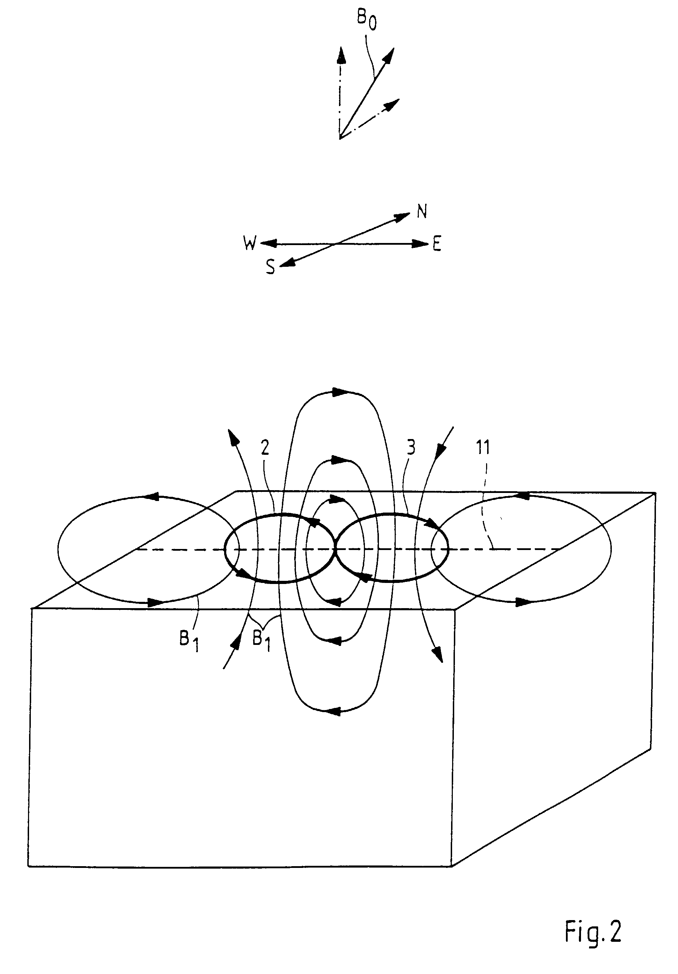

Fig. 2 veranschaulicht einen räumlichen Ausschnitt aus einem Teil der Erdoberfläche, der mit Hilfe der Detektionsspule 1 bestehend aus zwei Teilspulen 2, 3 vermessen werden soll. Dabei sind die magnetischen Feldlinien, die durch den NF-Anregungsimpuls durch die Detektionsspule 1 erzeugt werden, angedeutet. Dem Anregungsmagnetfeld B₁ ständig überlagert ist das natürliche Magnetfeld B₀ der Erde. Damit das Anregungsfeld B₁ in möglichst großen Bereichen senkrecht zum Erdfeld B₀ ist, empfiehlt es sich, die Detektionsspule 1 so auszurichten, daß die Verbindungslinie 11 der Mittelpunkte ihrer Teilspulen 2, 3 im wesentlichen in West-östlicher-Richtung verläuft.

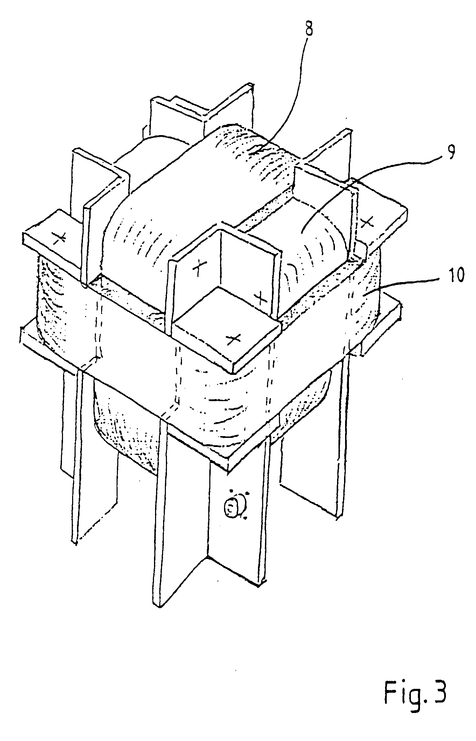

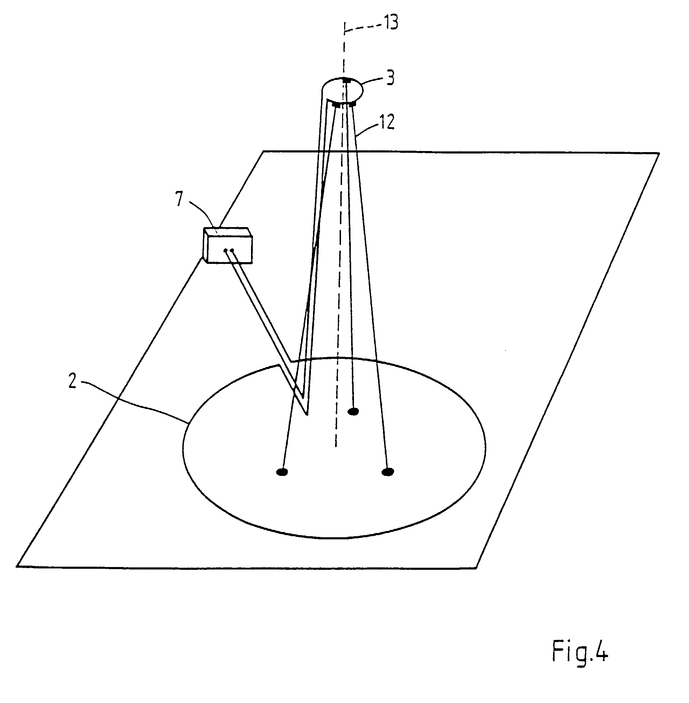

Fig. 3 zeigt eine Ausführungsform der erfindungsgemäßen Kompensationsspulen 8, 9, 10, die untereinander orthogonal sind und entsprechend in einem räumlichen kartesischen Koordinatensystem jeden beliebigen Vektor eines lokalen magnetischen Störfeldes nach Größe, Richtung und Orientierung aufnehmen können. Während zumindest eine der beiden Teilspulen 2 bzw. 3 der Detektionsspule 1 typischerweise einen Durchmesser von der Größenordnung 10 m bis 100 m aufweist, sind die Kompensationsspulen 8, 9, 10 relativ kompakt ausgeführt. Im gezeigten Beispiel besitzt jede dieser Spulen ca. 670 Windungen mit einer mittleren Länge pro Windung von 0,5 m, d.h. die gesamte Drahtlänge pro Spule beträgt ca. 335 m. Die einzelnen Kompensationsspulen, 8, 9, 10 haben jeweils eine Induktivität L≈80 mH und einen ohmschen Widerstand R≈13 Q. Bei einer Frequenz von 2 kHz ist der Widerstand aufgrund der Induktivität etwa 1 kΩ. Die einzelnen Kompensationsspulen 8, 9, 10 besitzen typischerweise zwischen 500 und 1000 Windungen. Fig. 4 stellt schematisch eine besonders bevorzugte Ausführungsform der erfindungsgemäßen Meßeinrichtung dar, bei der die Teilspule 3 der Detektionsspule 1 in räumlichem Abstand von der Erdoberfläche angeordnet ist, so daß von ihr weitgehend kein NMR-Signal aus den unter ihr liegenden Bodenstrukturen empfangen wird, während die Teilspule 2 im wesentlichen sämtliche Signale aus der Kernresonanzanregung des unter ihr liegenden Bodenbereiches aufnimmt. Die Teilspule 3 ist auf einem Gestell 12 derart montiert, daß die Verbindungslinie 13 zwischen den Mittelpunkten der beiden Teilspulen 2, 3 senkrecht zur Erdoberfläche steht.

Die von der Erdoberfläche entfernt angeordnete Teilspule 3 weist im Verhältnis zu der unter ihr auf der Erdoberfläche angeordneten Teilspule 2 einen relativ geringen Durchmesser und eine entsprechend höhere Windungszahl ihrer Wicklung auf. Aufgrund ihres kompakten Aufbaus kann die Teilspule 3 mit einer in der Zeichnung nicht dargestellten Kühlvorrichtung versehen sein, um den ohmschen Widerstand und das elektrische Rauschen in der Teilspule 3 zu verringern. Die Teilspule 3 dient damit ausschließlich der Kompensation von homogenen Fernstörungen, während die Kompensationsspulen 8, 9, 10 die Kompensation des inhomogenen Anteils der Fernstörungen aufgrund von lokalen Stromleitstrukturen im Boden übernehmen, die erfahrungsgemäß um ein bis zwei Größenordnungen geringer sind als der homogene Anteil. Es sei erwähnt, daß statt des gezeigten Satzes von drei Kompensationsspulen 8, 9, 10 auch mehrere Sätze von Kompensationsspulen verwendet werden können.

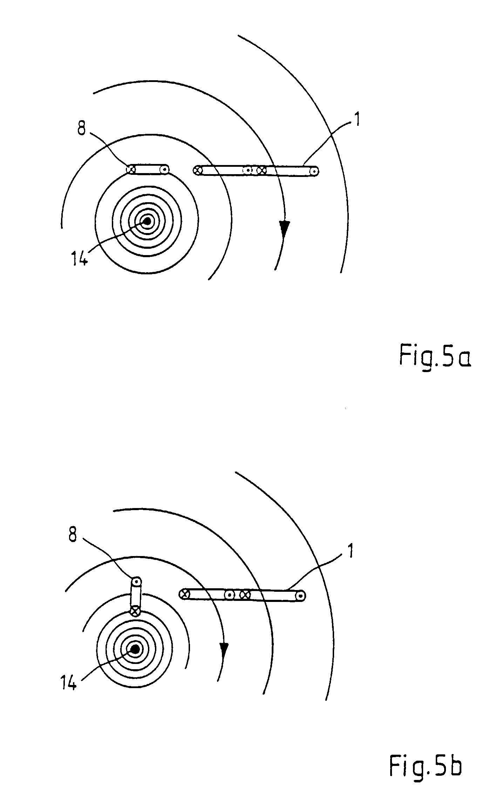

Fig. 5 schließlich zeigt mögliche Ausrichtungen einer einfachen Kompensationsspule 8 relativ zu einer Detektionsspule 1 und relativ zu einer Störung 14. Im Falle von Fig. 5a wird deutlich, daß keine Kompensation der lokalen inhomogenen Störung durch die Kompensationsspule 1 erfolgen kann, da die vom Störzentrum 14 ausgehenden Magnetfeldlinien in der Spulenebene der Kompensationsspule 8 liegen. Eine optimale Kompensation hingegen wird in der relativen Konfiguration nach Fig. 5b erreicht, wo die Magnetfeldlinien der Störquelle 14 im wesentlichen senkrecht die Spulenebene der Kompensationsspule 8 durchsetzen.

## Patentansprüche

1. Meßeinrichtung mit mindestens einer Detektionsspule (1) zum Detektieren magnetischer Kernresonanz (NMR) aus einem Empfindlichkeitsbereich der Detektionsspule (1) im Erdboden, wobei durch wiederholte kohärente Anregung im Empfindlichkeitsbereich jeweils Kernspins im Erdfeld zur Präzession angeregt werden und in der Detektionsspule (1) eine NMR-Induktionsspannung erzeugen, welche einem ersten Verstärker (7) zugeführt wird, wobei mindestens eine Kompensationsspule (8, 9 oder 10) zur zusätzlichen Kompensation räumlich inhomogener Störfelder vorgesehen ist, deren Induktionssignal einem zweiten Verstärker (18, 19 oder 20) mit einstellbarem Verstärkungsfaktor zugeführt wird,
dadurch gekennzeichnet,
daß die Detektionsspule (1) aus mindestens zwei gegensinnig gewickelten , elektrisch in Serie oder parallel geschalteten Teilspulen (2, 3) mit parallelen Spulenachsen besteht,und daß mehrere identische, an unterschiedlichen Orten angeordnete Systeme mit jeweils mindestens drei Kompensationsspulen (8, 9, 10) vorgesehen sind, die so gegeneinander verkippt angeordnet sind, daß damit jedes beliebig orientierte Vektorsignal der inhomogenen Störfelder empfangen, vektoriell rekonstruiert und zur Kompensation der Störfelder von dem aus der Detektionsspule (1) kommenden und im Verstärker (7) hochverstärkten Signal subtrahiert wird.

2. Meßeinrichtung nach Anspruch 1, dadurch gekennzeichnet, daß die Kompensationsspulen (8, 9, 10) eines jeden Systems jeweils drei gegenseitig orthogonal angeordnete Spulen sind.

3. Meßeinrichtung nach einem der vorhergehenden Ansprüche, dadurch gekennzeichnet, daß die räumliche Positionierung, die Windungszahlen, die Querschnittsflächen und die Permeabilität des Spulenmaterials der Teilspulen (2, 3) der Detektionsspule (1) so ausgewählt sind, daß ein räumlich homogenes magnetisches Stör-Wechselfeld in der Detektionsspule (1) in Näherung keine Induktionsspannung erzeugt, während ein im Vergleich zur Störung kleineres NMR-Signal aus dem Empfindlichkeitsbereich der gesamten Detektionsspule (1) im Erdboden nicht kompensiert wird.

4. Meßeinrichtung nach einem der vorhergehenden Ansprüche, dadurch gekennzeichnet, daß mindestens eine der Teilspulen (3) der Detektionsspule (1) in räumlichem Abstand von der Erdoberfläche angeordnet ist, so daß von ihr kein NMR-Signal aus den unter ihr liegenden Bodenkonstrukturen empfangen wird.

5. Meßeinrichtung nach Anspruch 4, dadurch gekennzeichnet, daß die von der Erdoberfläche entfernt angeordnete Teilspule (3) einen kleineren Durchmesser und eine höhere Windungszahl aufweist als eine auf der Erdoberfläche plazierte andere Teilspule (2) der Detektionsspule (1) .

6. Meßeinrichtung nach Anspruch 4 oder 5, dadurch gekennzeichnet, daß die von der Erdoberfläche entfernt angeordnete Teilspule (3) mit ihrer Spulenebene parallel zur Erdoberfläche angeordnet ist.

7. Meßeinrichtung nach Anspruch 6, dadurch gekennzeichnet, daß die Verbindungslinie (13) der Mittelpunkte der von der Erdoberfläche entfernt angeordneten Teilspule (3) und einer unterhalb von dieser auf der Erdoberfläche plazierten Teilspule (2) senkrecht zur Erdoberfläche steht.

8. Meßeinrichtung nach einem der Ansprüche 5 bis 7, dadurch gekennzeichnet, daß die zur Detektionsspule (1) gehörenden Teilspulen (2) und (3), die auf der Erdoberfläche bzw. von der Erdoberfläche entfernt angeordnet sind, durch ein Kühlsystem je einzeln oder gemeinsam gekühlt werden.

9. Verfahren zum Betrieb einer Meßeinrichtung nach einem der vorhergehenden Ansprüche, dadurch gekennzeichnet, daß durch wiederholte kohärente Anregung jeweils Kernspins aus dem Empfindlichkeitsbereich der Detektionsspule (1) im natürlichen Magnetfeld der Erde zur Präzession angeregt werden und in der Detektionsspule (1) ein NMR-Induktionssignal erzeugen, und daß dem Induktionssignal aus der Detektionsspule (1) mit entgegengesetztem Vorzeichen Induktionssignale aus den Kompensationsspulen (8, 9, 10) zu einem Gesamtsignal überlagert werden, wobei die Gesamtsignale aller Anregungen akkumuliert werden.

10. Verfahren nach Anspruch 9, dadurch gekennzeichnet, daß die Induktionssignale aus der oder den Kompensationsspulen (8, 9, 10) so verstärkt werden, daß das Gesamtsignal von Detektionsspule (1) und Kompensationsspulen (8, 9, 10) minimiert wird.

11. Verfahren nach Anspruch 10, dadurch gekennzeichnet, daß das gesamte Induktionssignal der Kompensationsspulen (8, 9, 10) durch entsprechende Plazierung der Kompensationsspulen (8, 9, 10) in der Nähe der Detektionsspule (1) maximiert wird.

12. Verfahren nach Anspruch 11, dadurch gekennzeichnet, daß nach der Plazierung die räumliche Orientierung der Kompensationssspulen (8, 9, 10) so variiert wird, daß das gesamte Induktionssignal aus den Kompensationsspulen (8, 9, 10) maximal wird.

13. Verfahren nach Anspruch 12, dadurch gekennzeichnet, daß nach Maximierung des gesamten Induktionssignales der Kompensationsspulen (8, 9, 10) lediglich eine einzige Kompensationsspule mit der gleichen Plazierung so orientiert wird, daß sie entsprechend dem mit Hilfe der Vielzahl von Kompensationsspulen (8, 9, 10) aufgefundenen Störfeldvektor das maximal mögliche Störsignal an dieser Stelle aufnimmt, und daß das Signal aus der einzigen Kompensationsspule von dem Signal aus der Detektionsspule (1) subtrahiert wird, wobei durch Variation eines Verstärkungsfaktors für das Signal aus der Kompensationsspule das zeitliche Integral über das gleichgerichtete Differenzsignal minimiert wird.

14. Verfahren nach Anspruch 11, dadurch gekennzeichnet, daß das durch Plazierung der Kompensationsspulen (8, 9, 10) maximierte Induktionssignal vor einer Gleichrichtung von dem Signal aus der Detektionsspule (1) subtrahiert wird, wobei individuelle Verstärkungsfaktoren für jede einzelne Kompensationsspule (8, 9, 10) derart variiert werden, daß das zeitliche Integral über das gleichgerichtete Differenzsignal minimal wird.

15. Verfahren nach Anspruch 11, dadurch gekennzeichnet, daß nach der Plazierung der Kompensationsspulen (8, 9, 10) deren gesamtes Induktionssignal durch Variation von individuellen Verstärkungsfaktoren für jede einzelne Kompensationsspule maximiert wird, und daß anschließend das optimierte Signal aus den Kompensationsspulen (8, 9, 10) von dem Signal aus der Detektionsspule (1) subtrahiert wird, wobei durch Variation eines gemeinsamen Verstärkungsfaktors für das gesamte Signal aus den Kompensationsspulen (8, 9, 10) das zeitliche Integral über das gleichgerichtete Differenzsignal minimiert wird.

16. Verfahren nach einem der Ansprüche 9 bis 15, dadurch gekennzeichnet, daß nach jeder Anregung an das Gesamtsignal ein Spektrum mit mehreren Spektrallinien angefittet wird, und daß dieses Spektrum vom Gesamtsignal subtrahiert wird.

17. Verfahren nach Anspruch 16, dadurch gekennzeichnet, daß das Anfitten des Spektrums mit dem Linear-Prediction-Verfahren oder mit dem Maximum-Entropy-Verfahren erfolgt.

18. Verfahren nach einem der Ansprüche 9 bis 17, dadurch gekennzeichnet, daß das akkumulierte, digitalisierte zeitliche Signal aus der Detektionsspule (1) und der oder den Kompensationsspulen (8, 9, 10) fouriertransformiert wird, um ein Frequenzspektrum der NMR-Signale aus dem untersuchten Bereich des Erdbodens zu erhalten.

## Claims

1. Measuring means with at least one detection coil (1) for detecting the nuclear magnetic resonance (NMR) from a sensitivity region of the detection coil (1) in the earth, wherein through repeated coherent excitation in the sensitivity region, nuclear spins in the earth field, in each case, are excited for precession and generate an NMR inductance voltage in the detection coil (1) which is supplied to a first amplifier (7) wherein at least one compensation coil (8, 9 or 10) is provided for additional compensation of spatially inhomogeneous interfering fields, the inductance signal of which is supplied to a second amplifier (18,19 or 20) with adjustable amplification factor,
characterized in that
the detection coil (1) consists of at least two oppositely wound partial coils (2,3), electrically connected in series or in parallel with parallel coil axes, and that several identical systems arranged at different locations are provided with at least three compensation coils (8,9,10), respectively, which are tilted with respect to one another such that any vector signal of the inhomogeneous interfering fields oriented in any given way is received, reconstructed vectorially and is subtracted for compensation of the interfering fields from the signal of the detection coil (1) amplified in the amplifier (7).

2. Measuring means according to claim 1, characterized in that the compensation coils (8,9,10) of each system are three coils which are mutually orthogonal in each case.

3. Measuring means according to one of the preceding claims, characterized in that the spatial positioning, the number of windings, the cross-sectional surfaces and the permeability of the coil material of the partial coils (2,3) of the detection coil (1) are selected such that a spatially homogeneous alternating magnetic interfering field in the detection coil (1) approximately does not create an inductance voltage, whereas an NMR signal from the sensitivity region of the entire detection coil (1) in the earth which is smaller as compared with the interference is not compensated for.

4. Measuring means according to one of the preceding claims, characterized in that at least one of the partial coils (3) of the detection coil (1) is arranged at a spatial distance from the earth surface such that it does not receive an NMR signal from the ground constructions lying beneath it.

5. Measuring means according to claim 4, characterized in that the partial coil (3) arranged remotely from the earth surface comprises a smaller diameter and a larger number of windings than another partial coil (2) of the detection coil (1) arranged on the earth surface.

6. Measuring means according to claim 4 or 5, characterized in that the coil plane of the partial coil (3) arranged remotely from the earth surface, is arranged in parallel to the earth surface.

7. Measuring means according to claim 6, characterized in that the connecting line (13) of the centers of the partial coil (3) arranged remotely from the earth surface, and of a partial coil (2) located below it on the earth surface, is directed perpendicularly to the earth surface.

8. Measuring means according to one of claims 5 to 7, characterized in that the partial coils (2) and (3) which belong to the detection coil (1) and are arranged on the earth surface or remotely from the earth surface are cooled by a cooling system individually or collectively.

9. Method of operating a measuring means according to one of the preceding claims, characterized in that by repeated coherent excitation nuclear spins, in each case, from the sensitivity region of the detection coil (1) in the natural magnetic field of the earth are excited to precess and generate an NMR inductance signal in the detection coil (1) and that the inductance signal from the detection coil (1) is overlapped with induction signals of opposed signs from the compensation coils (8,9,10) to form an entire signal, wherein the entire signals of all excitations are accumulated.

10. Method according to claim 9, characterized in that the induction signals from the compensation coil(s) (8,9,10) are amplified in such a manner that the entire signal from the detection coil (1) and compensation coils (8,9,10) is minimized.

11. Method according to claim 10, characterized in that the entire induction signal of the compensating coils (8,9,10) is maximized by corresponding placing of the compensation coils (8,9,10) in the proximity of the detection coil (1).

12. Method according to claim 11, characterized in that after placing the spatial orientation of the compensation coils (8,9,10) is varied in such a manner that the entire inductance signal from the compensation coils (8,9,10) reaches its maximum.

13. Method according to claim 12, characterized in that after maximising the entire inductance signal of the compensation coils (8,9,10) only one single compensation coil with the same location is oriented in such a manner that it receives the maximum possible interference signal at this location according to the interfering field vector found by means of the plurality of compensation coils (8,9,10), and that the signal from the single compensation coil is subtracted from the signal of the detection coil (1), wherein the time integral over the rectified differential signal is minimized by variation of an amplification factor for the signal from the compensation coil.

14. Method according to claim 11, characterized in that the inductance signal maximized by placing the compensation coils (8,9,10) is subtracted before rectification from the signal of the detection coil (1), wherein individual amplification factors are varied for each individual compensation coil (8,9,10) in such a manner that the time integral over the rectified differential signal is minimized.

15. Method according to claim 11, characterized in that the complete inductance signal of the compensation coils (8,9,10,) is maximized after placing through variation of individual amplification factors for each individual compensation coil, and that subsequently the optimized signal from the compensation coils (8,9,10) is subtracted from the signal of the detection coil (1), wherein through variation of a common amplification factor for the entire signal from the compensation coils (8,9,10) the time integral over the rectified differential signal is minimized.

16. Method according to one of the claims 9 through 15, characterized in that after each excitation, a spectrum with several spectral lines is fitted to the entire signal, and that this spectrum is subtracted from the entire signal.

17. Method according to claim 16, characterized in that the fitting of the spectrum is carried out with the linear prediction method or the maximum entropy method.

18. Method according to one of claims 9 through 17, characterized in that the accumulated, digitalized time signal from the detection coil (1) and one or several of the compensation coils (8,9,10) is Fourier-transformed to obtain a frequency spectrum of the NMR signals from the area of the earth to be examined.

## Revendications

1. Dispositif de mesure comportant au moins une bobine détectrice (1) pour détecter de la résonance magnétique nucléaire (RMN) dans le sol à partir d'une zone de sensibilité de la bobine détectrice (1), des spins nucléaires respectifs étant mis en précession dans le champ terrestre par une excitation cohérente répétée dans la zone de sensibilité, et produisant dans la bobine détectrice (1) une tension RMN induite qui est apportée à un premier amplificateur (7), au moins une bobine compensatrice (8, 9 ou 10) étant prévue pour la compensation d'appoint des champs perturbateurs spatialement non homogènes, bobine dont le signal induit est apporté à un deuxième amplificateur (18, 19 ou 20) à gain réglable,
**caractérisé** en ce que la bobine détectrice (1) est constituée d'au moins deux bobines partielles (2, 3) bobinées en sens contraires, montées électriquement en série ou en parallèle et à axes parallèles, et en ce que sont prévus plusieurs systèmes identiques, disposés en des emplacements différents et comportant chacun au moins trois bobines compensatrices (8, 9, 10), qui sont disposés en étant basculées les unes par rapport aux autres de telle sorte que chaque signal vectoriel, d'orientation quelconque, des champs perturbateurs non homogènes est ainsi reçu, vectoriellement reconstruit et, afin de compenser les champs perturbateurs, soustrait du signal provenant de la bobine détectrice (1) et amplifié à grand gain dans l'amplificateur (7).

2. Dispositif de mesure selon la revendication 1, **caractérisé** en ce que les bobines compensatrices (8, 9, 10) de chaque système consistent en trois bobines disposées orthogonalement les unes par rapport aux autres.

3. Dispositif de mesure selon une des revendications précédentes, **caractérisé** en ce que le positionnement dans l'espace, les nombres de spires, les aires de section et la perméabilité du matériau des bobines partielles (2, 3) de la bobine détectrice (1) sont choisis de telle sorte qu'un champ magnétique perturbateur alternatif spatialement homogène ne produit en approximation pas de tension induite dans la bobine détectrice (1), tandis qu'un signal RMN plus faible que la perturbation, provenant de la zone de sensibilité de l'ensemble de la bobine détectrice (1), n'est pas compensé dans le sol.

4. Dispositif de mesure selon une des revendications précédentes, **caractérisé** en ce qu'au moins une (3) des bobines partielles de la bobine détectrice (1) est disposée à distance, dans l'espace, de la surface du sol, de sorte qu'elle ne reçoit pas de signal RMN provenant des structures du sol qui se trouvent en dessous d'elle.

5. Dispositif de mesure selon la revendication 4, **caractérisé** en ce que la bobine partielle (3) disposée à distance de la surface du sol présente un plus petit diamètre et un plus grand nombre de spires que l'autre bobine partielle (2) de la bobine détectrice (1), placée sur la surface du sol.

6. Dispositif de mesure selon la revendication 4 ou 5, **caractérisé** en ce que la bobine partielle (3) disposée à distance de la surface du sol est disposée avec son plan de bobine parallèle à la surface du sol.

7. Dispositif de mesure selon la revendication 6, **caractérisé** en ce que la ligne de jonction (13) des centres de la bobine partielle (3) disposée à distance de la surface du sol et d'une bobine partielle (2) placée en dessous sur la surface du sol, est perpendiculaire à la surface du sol.

8. Dispositif de mesure selon une des revendications 5 à 7, **caractérisé** en ce que les bobines partielles (2 et 3), qui font partie de la bobine détectrice (1) et sont disposées respectivement sur la surface du sol et à distance de la surface du sol, sont refroidies conjointement ou individuellement, par un système de refroidissement respectif.

9. Procédé d'exploitation d'un dispositif de mesure selon une des revendications précédentes, **caractérisé** en ce que, par une excitation cohérente répétée, on met en précession des spins nucléaires respectifs dans le champ magnétique naturel du sol à partir de la zone de sensibilité de la bobine détectrice (1), et on produit dans la bobine détectrice (1) un signal RMN induit, et en ce qu'on superpose au signal induit provenant de la bobine détectrice (1) des signaux induits de signe opposé provenant des bobines compensatrices (8, 9, 10), pour former un signal global, les signaux globaux de toutes les excitations étant cumulés.

10. Procédé selon la revendication 9, **caractérisé** en ce que les signaux induits provenant de la ou des bobines compensatrices (8, 9, 10) sont amplifiés de telle sorte que le signal global de la bobine détectrice (1) et des bobines compensatrices (8, 9, 10) est minimisé.

11. Procédé selon la revendication 10, **caractérisé** en ce que le signal induit global des bobines compensatrices (8, 9, 10) est maximisé par un placement correspondant des bobines compensatrices (8, 9, 10) à proximité de la bobine détectrice (1).

12. Procédé selon la revendication 11, **caractérisé** en ce que, à la suite du placement, on fait varier l'orientation dans l'espace des bobines compensatrices (8, 9, 10) de façon que le signal induit global provenant des bobines compensatrices (8, 9, 10) soit maximal.

13. Procédé selon la revendication 12, **caractérisé** en ce que, à la suite de la maximisation du signal induit global des bobines compensatrices (8, 9, 10), une seule bobine compensatrice est, en conservant le même placement, orientée de telle sorte que, conformément au vecteur de champ perturbateur reconnu à l'aide de la pluralité de bobines compensatrices (8, 9, 10), elle reçoit le signal perturbateur maximal possible en cet endroit, et en ce que le signal provenant de cette seule bobine compensatrice est soustrait du signal de la bobine détectrice (1), l'intégrale en fonction du temps du signal différentiel redressé étant minimisée en faisant varier le gain du signal provenant de la bobine compensatrice.

14. Procédé selon la revendication 11, **caractérisé** en ce que le signal induit maximisé par le placement des bobines compensatrices (8, 9, 10) est soustrait du signal de la bobine détectrice (1) avant redressement, l'intégrale en fonction du temps du signal différentiel redressé étant minimisée en faisant varier des gains individuels pour chaque bobine compensatrice individuelle (8, 9, 10).

15. Procédé selon la revendication 11, **caractérisé** en ce que, à la suite du placement des bobines compensatrices (8, 9, 10), leur signal induit global est maximisé en faisant varier des gains individuels pour chaque bobine compensatrice individuelle, et en ce que le signal optimisé provenant des bobines compensatrices (8, 9, 10) est ensuite soustrait du signal provenant de la bobine détectrice (1), l'intégrale en fonction du temps du signal différentiel redressé étant minimisée en faisant varier un gain commun pour le signal global provenant des bobines compensatrices (8, 9, 10).

16. Procédé selon une des revendications 9 à 15, **caractérisé** en ce que, à la suite de chaque excitation, on affecte au signal global un spectre comprenant plusieurs raies spectrales, et en ce que ce spectre est soustrait du signal global.

17. Procédé selon la revendication 16, **caractérisé** en ce que l'affectation du spectre s'effectue selon le procédé de prédiction linéaire ou selon le procédé d'entropie maximale.

18. Procédé selon une des revendications 9 à 17, **caractérisé** en ce que le signal de temps numérisé cumulé provenant de la bobine détectrice (1) et de la ou les bobines compensatrices (8, 9, 10) est transformé par transformation de Fourier, afin d'obtenir un spectre de fréquences des signaux RMN provenant de la zone analysée du sol.
